(19) Europäisches Patentamt
European Patent Office
Office européen des brevets

(11) Veröffentlichungsnummer : **0 094 913**
**B1**

(12) **EUROPÄISCHE PATENTSCHRIFT**

(45) Veröffentlichungstag der Patentschrift : **11.11.87**

(51) Int. Cl.⁴ : **G 03 F 7/10**, C 08 F 20/60, C 08 F 20/36

(21) Anmeldenummer : **83810205.1**

(22) Anmeldetag : **13.05.83**

(54) **Photovernetzbare wasserlösliche Polymere, Verfahren zu ihrer Herstellung und ihre Verwendung.**

(30) Priorität : **19.05.82 CH 3128/82**

(43) Veröffentlichungstag der Anmeldung : **23.11.83 Patentblatt 83/47**

(45) Bekanntmachung des Hinweises auf die Patenterteilung : **11.11.87 Patentblatt 87/46**

(84) Benannte Vertragsstaaten : **CH DE FR GB LI NL**

(56) Entgegenhaltungen :
**EP-A- 0 021 019**
**DE-A- 2 626 769**
**DE-A- 2 626 795**

(73) Patentinhaber : **CIBA-GEIGY AG**
**Klybeckstrasse 141**
**CH-4002 Basel (CH)**

(72) Erfinder : **Roth, Martin, Dr.**
**Oberdorf**
**CH-1711 Giffers (CH)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Jouve, 18, rue St-Denis, 75001 Paris, France

**Beschreibung**

Die vorliegende Erfindung betrifft photovernetzbare wasserlösliche Polymere und Copolymere, die Maleinimidyl- und quaternäre Ammoniumgruppen enthalten und deren Verwendung als photographisches Aufzeichnungsmaterial.

Photopolymere werden als photographisches Aufzeichnungsmaterial verwendet, wobei organische Lösungsmittel und wässrige Basen oder Säuren als Entwickler dienen. Die Verarbeitung solcher Photopolymeren ist insofern nachteilig, als Absaugevorrichtungen notwendig sind und die Aufbereitung der Entwickler technisch aufwendiger ist.

Die DE-A-2 626 795 beschreibt substituierte Maleinimidylverbindungen, welche sich zur Herstellung von diversen lichtvernetzbaren Polymeren eignen. Diese Systeme weisen nicht immer eine ausreichende Lichtempfindlichkeit auf, und die Haftung der daraus hergestellten Beschichtungen auf der Unterlage ist nicht immer ganz zufriedenstellend.

In der US-A-4 229 519 und der EP-A-0 029 358 werden in Wasser lösliche und mit Wasser entwickelbare photovernetzbare Kompositionen vorgeschlagen, die als Photopolymere solche mit quarternären Ammoniumgruppen und äthylenisch ungesättigten Gruppen enthalten. Diese Photopolymeren können nur in einem unwirtschaftlichen Zweistufenverfahren (Polymerisation und Quaternisierung) hergestellt werden. Ferner müssen spezielle Photoinitiatorsysteme zur Erzielung einer ausreichenden Lichtempfindlichkeit eingesetzt werden. Ausserdem benötigen solche Materialien Inhibitoren zur Erreichung einer genügenden Dunkellagerstabilität. Aufgabe vorliegender Erfindung ist es, in einer Verfahrensstufe herstellbare und mit Wasser entwickelbare Photopolymere bereitzustellen, deren Lichtempfindlichkeit mit bekannten Photoinitiatoren gesteigert werden kann.

Gegenstand vorliegender Erfindung sind Maleinimidylgruppen und quarternäre Ammoniumgruppen enthaltende Homopolymere oder Copolymere mit einem Molekulargewicht von mindestens 1 000, gekennzeichnet durch Strukturelemente der Formel I

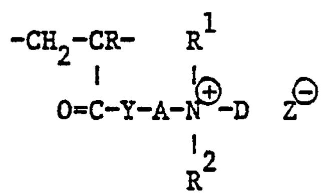

(I)

worin

R ein Wasserstoffatom oder Methyl ist,

Y ein Sauerstoffatom oder die NH-Gruppe bedeutet,

A lineares oder verzweigtes $C_2$-$C_6$-Alkylen ist,

$R^1$ und $R^2$ unabhängig voneinander $C_1$-$C_4$ Alkyl oder zusammen Tetramethylen, Pentamethylen oder 3-Oxapentylen sind,

D $C_1$-$C_4$-Alkyl oder ein Rest der Formeln

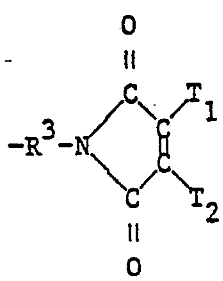 , 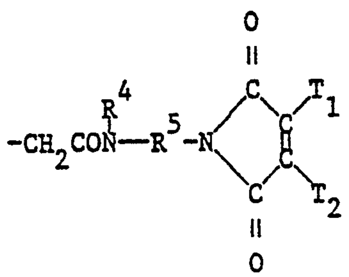 , 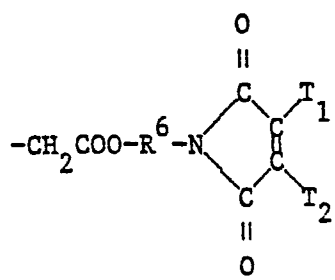

bedeutet, worin $R^3$ Alkylen, Oxaalkylen oder Benzylen ist, $R^4$ ein Wasserstoffatom oder $C_1$-$C_4$-Alkyl ist, $R^5$ ein zweiwertiger aliphatischer, cycloaliphatischer oder aromatischer Kohlenwasserstoffrest oder ein zweiwertiger aliphatischer oder aromatischer heterocyclischer Rest mit bis zu 18 C-Atomen darstellt und $R^6$ die Bedeutung von $R^5$ hat oder

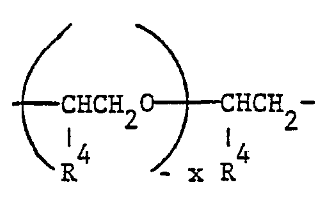

mit x gleich 1-29 und $R^4$ gleich einem Wasserstoffatom oder $C_1$-$C_4$-Alkyl ist, $T_1$ und $T_2$ unabhängig voneinander $C_1$-$C_4$-Alkyl oder zusammen unsubstituiertes oder durch $C_1$-$C_4$-Alkyl substituiertes Tri- oder Tetramethylen sind, und $Z^\ominus$ ein Anion ist, mit der Massgabe, dass, falls D gleich $C_1$-$C_4$-Alkyl ist, im Polymer Strukturelemente von mindestens einem äthylenisch ungesättigten Monomer, das eine Maleinimidylgruppe der Formel

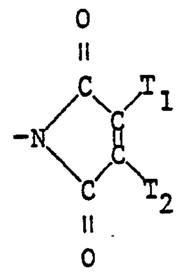

trägt, enthalten sind, wobei noch zusätzliche Strukturelemente, die sich von äthylenisch ungesättigten maleinimidgruppenfreien Comonomeren ableiten, vorhanden sein können.

Das Molekulargewicht kann von 1 000 bis 2 000 000, bevorzugt 10 000 bis 1 000 000 und insbesondere von 10 000 bis 500 000 betragen. Bevorzugt sind die Copolymeren.

A kann als lineares oder verzweigtes Alkylen besonders 2 bis 4 C-Atome enthalten und kann z. B. 1,6-, 1,5-, 1,4-, 1,3- oder 1,2-Hexylen, 1,5- oder 1,3- oder 1,2-Hexylen, 1,5- oder 1,3-Pentylen, 1,4-, 1,3- oder 1,2-Propylen und Aethylen sein. Bevorzugt ist A Propylen und besonders Aethylen.

$R^1$ und $R^2$ als Alkyl können linear oder verzweigt sein und enthalten bevorzugt 1 oder 2 C-Atome. Beispiele sind n-Butyl, iso-Butyl, tertiär-Butyl, n-Propyl, iso-Propyl, Aethyl und Methyl. $R^1$ und $R^2$ können auch gegebenenfalls durch $C_1$-$C_4$-Alkyl, besonders Methyl, substituiertes Tetramethylen, Pentamethylen oder 3-Oxapentylen sein.

D als $C_1$-$C_4$-Alkyl kann die für $R^1$ und $R^2$ beschriebenen Bedeutungen haben und ist bevorzugt Methyl oder Aethyl.

$R^3$ als Alkylen kann linear oder verzweigt sein und 2 bis 18, bevorzugt 2 bis 12 und besonders 2 bis 6 C-Atome enthalten und als Oxaalkylen 2 bis 6, vorzugsweise 2 bis 4 C-Atome. Beispiele sind Aethylen, 1,2- oder 1,3-Propylen, 1,4- oder 1,3-Butylen, Pentylen, Hexylen, Octylen, Decylen, Dodecylen, Octadecylen, Decyläthylen, Tetradecyläthylen, Hexadecyläthylen und 3-Oxapentylen.

$R^4$ kann als Alkyl linear oder verzweigt sein. Bevorzugt ist $R^4$ ein Wasserstoffatom.

Der Rest $R^5$ enthält bevorzugt bis zu 12 C-Atome. Als aliphatischer Rest ist $R^5$ bevorzugt gegebenenfalls durch Heteroatome wie O, S und $NR^4$ unterbrochenes Alkylen, das linear oder verzweigt sein kann. Bevorzugt ist $R^5$ hier Alkylen und Oxaalkylen mit 1 bis 12 C-Atomen. $R^5$ als cycloaliphatischer Rest enthält bevorzugt 5 oder 6 Ring-C-Atome und ist insbesondere gegebenenfalls durch 1 bis 4 Alkylgruppen mit 1 bis 4 C-Atomen, z. B. Methyl, substituiertes Cyclopentylen und Cyclohexylen. Besonders bevorzugt ist 1,3- und 1,4-Cyclohexylen.

$R^5$ als aromatischer Kohlenwasserstoffrest kann z. B. ein carbocyclisch aromatischer Rest mit bevorzugt 6 bis 16 C-Atomen oder ein araliphatischer Rest mit bevorzugt 7 bis 16 C-Atome sein. Beispiele sind 1,2-, 1,3- und 1,4-Phenylen, 1,3-Toluylen, 1,7- und 2,7-Naphthylen, 1,2-, 1,3- oder 1,4-Benzylen und bicyclische aromatische Gruppen der Formel

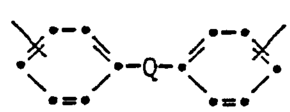

worin Q für eine direkte Bindung, —O—, —S—, —SO—, —$SO_2$—, —CO,

$$-O\underset{\underset{O}{\|}}{C}-,\quad -O-\underset{\underset{O}{\|}}{C}-O-$$

—$NR^4$—, Alkylen mit 1 bis 6 C-Atomen, Alkyliden mit 2-6 C-Atomen oder Cycloalkyliden mit 5 oder 6 Ring-C-Atomen steht. Die freien Bindungen befinden sich bevorzugt in 4,4'-Stellung.

$R^5$ als heterocyclisch-aliphatischer oder heterocyclisch-aromatischer Rest kann 4 bis 12 C-Atome enthalten. Bevorzugt handelt es sich um 5 oder 6-gliedrige Ringe mit ein oder 2 Heteroatomen wie N oder O.

Im Polyoxaalkylenrest für $R^6$ ist x bevorzugt 1 bis 12, insbesondere 1 bis 6 und $R^4$ ein

Wasserstoffatom oder Methyl.

$T_1$ und $T_2$ sind insbesondere Methyl und Tetramethylen.

$Z^{\ominus}$ ist besonders das Anion eines Quaternierungsmittels wie z. B. F, Cl, Br, $SO_4$, $C_1$-$C_4$-Alkyl $OSO_3$, und Sulfonat. Das Sulfonatanion kann sich z. B. von aliphatischen, cycloaliphatischen und aromatischen Sulphonsäuren ableiten, z. B. Methyl-, Aethyl-, Propyl-, Butyl-, Pentyl, Hexyl, Cyclohexyl-, Phenyl-, Benzyl-, Toluyl- oder Naphthylsulfonsäure.

Eine bevorzugte Untergruppe der Strukturelemente der Formel I sind solche, worin Y ein Sauerstoffatom, A lineares $C_2$-$C_4$-Alkylen, insbesondere Aethylen, $R^1$ und $R^2$ $C_1$- oder $C_2$-Alkyl, besonders Methyl und D ein Rest der Formel

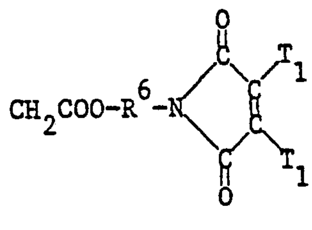

sind, worin $R^6$ Aethylen, 3-Oxapentylen oder 1,3-Propylen ist und $T_1$ für Methyl steht ; und $Z^{\ominus}$ Halogenid, besonders Chlorid ist.

Soweit es sich um Copolymere handelt, weisen diesselben ausser den die Maleinimidgruppen tragenden Molekülkettengliedern vorzugsweise solche Molekülkettenglieder auf, welche sich von den folgenden maleinimidgruppenfreien Comonomeren ableiten :

α-Olefine, Vinylhalogenide, beispielsweise Vinylbromid, Vinylchlorid und Vinylfluorid, Vinylidene, beispielsweise Vinylidenchlorid, Nitrile α,β-ungesättigter Säuren, beispielsweise Acrylnitril oder Methacrylnitril, α,β-ungesättigte Säuren, ihre Ester oder Halogenderivate, beispielsweise Acrylsäure, Methacrylsäure, Crotonsäure, Maleinsäure, Methylmethacrylat, Aethylacrylat, Propylacrylat, Butylacrylat, Octylacrylat, 2-Aethyl-hexylacrylat, Aethylmethacrylat, Isopropylmethacrylat, Dimethylaminoäthylmethacrylat, Diäthylaminoäthylacrylat, Glycidylmethacrylat, Gycidylacrylat oder Chlormethylmethacrylat, α,β-ungesättigte Carbonsäureamide und ihre Derivate, beispielsweise Acrylamid, Methacrylamid, aromatische Vinylverbindungen, beispielsweise Styrol, Methylstyrol, Vinyltoluol oder α-Chlorstyrol, Vinylketone, beispielsweise Methylvinylketon, Vinylester, beispielsweise Vinylacetat, heterocyclische Vinylverbindungen, beispielsweise Vinylpyridin, Vinylpyrrolidon sowie Vinyläther.

Weiter sind auch äthylenisch ungesättigte Comonomere geeignet, die die zuvor definierte Maleinimidgruppe enthalten. Solche Comonomeren können auch dann verwendet werden, wenn D nicht $C_1$-$C_4$-Alkyl ist. Solche Comonomeren sind z. B. in der DE-A-26 26 769 und der EP-A-0 021 019 beschrieben. Es handelt sich im wesentlichen um Acrylsäure- und Methacrylsäureester und -amide sowie Vinyläther, die die Maleinimidgruppe an die Ester-, Amid- bzw. Aethergruppe gebunden enthalten. Bevorzugt sind solche Comonomeren der Formeln

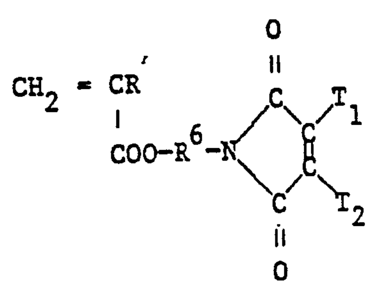

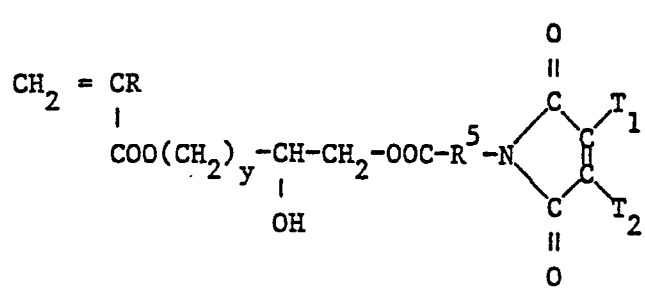

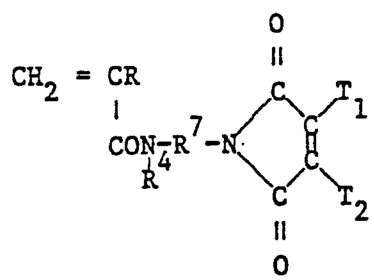

und

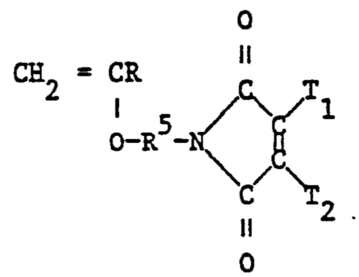

worin R, $R^4$, $R^5$, $R^6$ und $T_1$ die zuvor angegebenen Bedeutungen haben, $R^7$ gleich $R^5$ oder $—CO—R^5—$ ist und y für 1 oder 2 steht.

Die erfindungsgemässen Polymeren enthalten bevorzugt 10 bis 100 Mol-%, besonders 40 bis 100 Mol-% Strukturelemente mit Maleinimidylgruppen der Formel

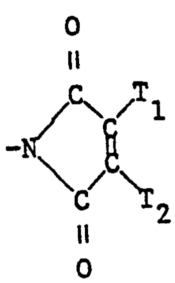

Die Strukturelemente der Formel I sind in den Polymeren bevorzugt zu 5 bis 90 Mol-%, besonders 10 bis 60 Mol-% enthalten.

Die Verwendung verschiedener Comonomerer gestattet es, den erfindungsgemässen Polymeren gewünschte Eigenschaften zu verleihen, z. B. Lichtempfindlichkeit, Glasübergangstemperatur, Hydrophilie, Hydrophobie, Anfärbbarkeit und Löslichkeit.

Die erfindungsgemässen Polymeren können nach verschiedenen bekannten Verfahren hergestellt werden.

In einer Ausführungsform können Homo- und Copolymerisate mit mindestens einem äthylenisch ungesättigten Comonomeren, wobei das Comonomere für $D = C_1$-$C_4$ Alkyl eine Maleinimidylgruppe enthält, mit Strukturelementen der Formeln II oder III

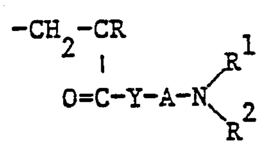 (II) 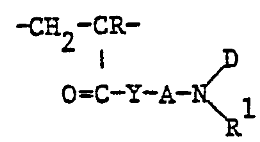 (III)

in einem organischen Lösungsmittel und bevorzugt in äquimolaren Mengen, gegebenenfalls unter Erhitzen bis zu etwa 100 °C, mit einem Quaternisierungsmittel der Formeln DZ bzw. $R^2Z$ umgesetzt werden. Die Ausgangspolymeren werden hierbei nach bekannten Polymerisationsverfahren aus den entsprechenden Monomeren und gegebenenfalls Comonomeren erhalten, wie sie z. B. in DE-A-26 26 769 beschrieben sind.

Die Quarternierungsmittel DZ sind neu und deren Verwendung als Quarternierungsmittel in einem Verfahren zur Herstellung der erfindungsgemässen Polymeren mit Strukturelementen der Formel I aus Polymeren mit Strukturelementen der Formel II ist ebenfalls ein Gegenstand vorliegender Erfindung. Sie werden nach bekannten Verfahren hergestellt, z. B. die Veresterung bzw. Amidierung von Verbindungen der Formeln

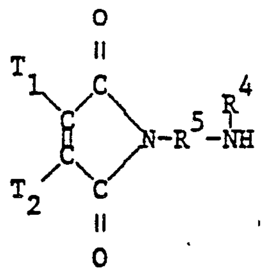 bzw. 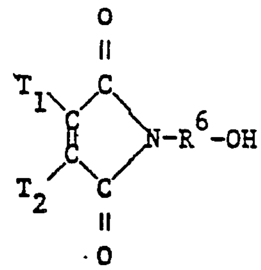

mit Halogenessigsäure bzw. ihrer ester- oder amidbildenden Derivaten. Die Umsetzung mit Hydroxyessigsäure ergibt entsprechende Hydroxyderivate, die in bekannter Weise, wie auch Verbindungen der Formel

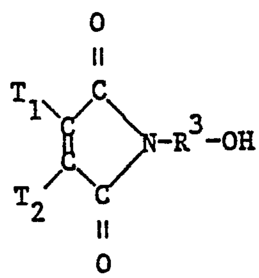

in Halogenderivate, Sulfonate und Sulfate überführt werden können.

In einer weiteren Ausführungsform zur Herstellung der erfindungsgemässen Polymeren können ungesättigte Monomere der Formel IV,

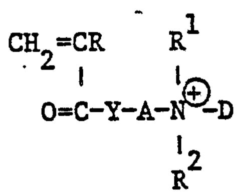 $Z^{\ominus}$ (IV)

gegebenenfalls zusammen mit mindestens einem äthylenisch ungesättigten Comonomeren, das für D = $C_1$-$C_4$-Alkyl eine Maleinimidylgruppe enthält, in organischer Lösung in an sich bekannter Weise in Gegenwart eines Radikalinitiators, wie z. B. Azobisisobutyronitril, bei Temperaturen zwischen ca. 40-120 °C polymerisiert werden.

Die Verbindungen der Formel IV, in denen D nicht $C_1$-$C_4$-Alkyl ist und die durch Quaternisierung von Verbindungen der Formel

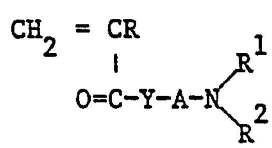

mit DZ erhalten werden, sind neu und deren Verwendung in einem Verfahren zur Herstellung der erfindungsgemässen Polymeren durch Polymerisation alleine oder zusammen mit einem äthylenisch ungesättigten Comonomeren in organischer Lösung in Gegenwart eines Radikalinitiators ist ebenfalls ein Gegenstand der Erfindung.

In einer besonders vorteilhaften Ausführungsform können die erfindungsgemässen Polymeren nach einem neuen Verfahren hergestellt werden, das auch Gegenstand der Erfindung ist. Es ist dadurch gekennzeichnet, dass man ein Monomer der Formeln V oder VI

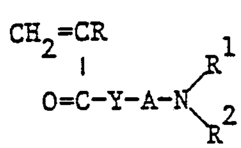 (V) 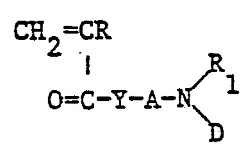 (VI)

alleine oder zusammen mit mindestens einem äthylenisch ungesättigten Comonomer, das für D = $C_1$-$C_4$

Alkyl eine Maleinimidylgruppe enthält, in organischer Lösung und in Gegenwart eines Radikalinitiators und eines Quaternierungsmittels DZ bzw. $R^2Z$ polymerisiert. Die erfindungsgemässen Polymeren können somit wirtschaftlich in einem Verfahrenschritt durch gleichzeitige Polymerisation und Quaternisierung hergestellt werden, ohne dass hierbei mögliche Vernetzungsreaktionen beobachtet werden. Zur Durchführung der Reaktion werden die Reaktanden zusammen mit einem Radikalinitiator wie Azo-bisisobutyronitril in einem organischen Lösungsmittel erwärmt. Die Temperatur richtet sich im wesentlichen nach dem verwendeten Radikalinitiator und kann z. B. 40 bis 120 °C betragen.

Geeignete Lösungsmittel für die Herstellverfahren sind z. B. Alkohole wie Methanol, Aethanol und Methylcellosolve sowie polare aprotische Lösungsmittel, wobei die Lösungsmittel alleine oder in Mischungen aus mindestens zwei Lösungsmitteln verwendet werden können. Beispiele sind :

Aether wie Diäthyläther, Dibutyläther, Tetrahydrofuran, Dioxan, Methyläthylenglykol, Dimethyläthylenglykol, Dimethyldiäthylenglykol, Diäthyldiäthylenglykol, Dimethyltriäthylenglykol, halogenierte Kohlenwasserstoffe wie Methylenchlorid, Chloroform, Tetrachlorkohlenstoff, 1,2-Dichloräthan, 1,1,2-Trichloräthan, 1,1,2,2-Tetrachloräthan, Carbonsäureester und Lactone wie Essigsäureäthylester, Propionsäuremethylester, Benzoesäureäthylester, 2-Methoxyäthylacetat, γ-Butyrolacton, -Valerolacton und Mevalolacton, Carbonsäureamide und Lactame wie Formamid, Acetamid, N-Methylformamid, N,N-Dimethylformamid, N,N-Diäthylformamid, N,N-Dimethylacetamid, N,N-Diäthylacetamid, γ-Butyrolactam, -Caprolactam, N-Methylpyrrolidon, N-Methylcaprolactam, Tetramethylharnstoff, Hexamethylphosphorsäureamid, Sulfoxide wie Dimethylsulfoxid, Tetramethylsulfoxid, Sulfone wie Dimethylsulfon, Diäthylsulfon, Trimethylensulfon, Tetramethylensulfon, primäre, sekundäre und tertiäre Amine wie Methylamin, Aethylamin, Propylamin, Pyrrolidin, Piperidin, Morpholin, Dimethylamin, Diäthylamin, Methyläthylamin, Trimethylamin, Triäthylamin, N-Methylpyrrolidin, N-Methylpiperidin, N-Methylmorpholin, substituierte Benzole wie Chlorbenzol, Nitrobenzol und Kresol.

Die erhaltenen Polymerlösungen können gegebenenfalls nach Verdünnen und Zugabe von üblichen Zusatzstoffen als lichtempfindliche Beschichtungsmittel verwendet werden. Man kann aber auch das Polymer nach bekannten Verfahren aus den Lösungen isolieren, z. B. Ausfällen mit einem Nichtlösungsmittel, Ausfrieren oder Abdestillieren des Lösungsmittels. Die Polymeren und ihre Lösungen sind lagerstabil.

Durch die vorhandenen Maleinimidgruppen eignen sich die erfindungsgemässen Polymeren besonders zur Vernetzung unter dem Einfluss elektromagnetischer Wellen. Die Vernetzung führt zu unlöslichen Produkten. Durch bildmässige Belichtung und nachfolgende Entwicklung (Herauslösen des unvernetzten, unbelichteten Polymeranteiles) können so Reliefbilder erhalten werden. Neben der Verwendung als photographisches Aufzeichungsmaterial können die Polymeren auch zum Oberflächenschutz verschiedener Substrate wie Kunststoffe, Metalle, Glas, Holz und Keramik eingesetzt werden. Die Polymeren zeichnen sich durch eine gute Haftung auf den Substraten aus.

Den Polymeren bzw. den entsprechenden Beschichtungsmitteln können übliche Zusatzstoffe einverleibt werden, die die Lichtempfindlichkeit nicht negativ beeinflussen. Beispiele hierfür sind Mattierungsmittel, Netz- und Verlaufmittel, Füllstoffe, Farbstoffe oder Pigmente, Flammschutzmittel, Lichtschutzmittel und Antioxidantien.

Die maximale Lichtempfindlichkeit der erfindungsgemässen Polymeren liegt ohne Sensibilisatoren im Bereich zwischen 200-320 nm. Durch geeignete Wahl von Sensibilisatoren wird die Lichtempfindlichkeit erheblich erhöht und lässt sich auf das Licht diverser handelsüblicher Kopierlampen, wie z. B. Metall-Halogenlampen, maximal anpassen.

Geeignete Sensibilisatoren sind in der DE-A-26 26 769 beschrieben. Besonders geeignet sind substituierte Thioxanthone, die z. B. in der DE-A-30 18 891 beschrieben sind, z. B. Alkylester des 3-Carbon-7-methyl-thioxanthons. Die Sensibilisatoren werden bevorzugt in Mengen von 0,5-10 Gew.-%, bezogen auf das Polymer, eingesetzt. Es können auch Mischungen verschiedener Sensibilisatoren verwendet werden.

Die vorliegende Erfindung betrifft auch die aus den erfindungsgemässen Polymeren hergestellten lichtempfindlichen Materialien. Solche sind z. B. photographische Aufzeichnungsmaterialien für die grafische Industrie, Druckformen, speziell Offsetdruckformen, sowie Materialien für das Gebiet der Photofabrikation in der Elektronik, z. B. Photoresists für die Herstellung gedruckter Schaltungen.

Zu diesem Zweck werden die erfindungsgemässen Polymeren in organischen Lösungsmitteln gelöst und nach dem Zusatz diverser Hilfsstoffe aus das Trägermaterial aufgebracht.

Als Trägermaterialien werden die für das jeweilige Applikationsgebiet üblichen Schichtträger verwendet. Für photografische Aufzeichnungsmaterialien z. B. Folien aus Polyester, Celluloseacetat oder gegebenenfalls mit Kunststoff beschichtete Papiere, für Offsetdruckformen speziell behandeltes Aluminium, für die die Herstellung gedruckter Schaltungen kupferkaschierte Laminate.

Die Beschichtung kann nach üblichen bekannten Verfahren erfolgen, z. B. durch Tauchen, Rakelbeschichtung, Vorhanggiessverfahren, Aufpinseln, Sprayen und Reverse-roll-Beschichtung.

Nach dem Beschichten wird das Lösungsmittel durch Trocknen entfernt und es resultiert eine nichtklebrige, feste Schicht des lichtempfindlichen Polymers auf dem Träger. Nach der in üblicher Weise erfolgten bildmässigen Belichtung des Materials durch eine Photomaske werden die unbelichteten Stellen des Polymers durch Herauslösen in einem Entwickler entfernt und das Polymerrelief, bestehend aus vernetztem erfindungsgemässen Polymer freigelegt.

Als Entwickler dient bevorzugt normales Leitungswasser. Neben Wasser können aber auch Gemische von Wasser mit wassermischbaren organischen Lösungsmitteln (Alkohole, Ketone, Ester) und in gewissen Fällen auch organische Lösungsmittel, z. B. Aethylalkohol verwendet werden. Die Temperatur der Entwicklerlösung kann von + 5 °C bis ca. 90 °C variieren, bevorzugt zwischen 15° und 60°. Die Entwicklungszeit ist abhängig von der Schichtdicke und der Zusammensetzung des Polymers und kann zwischen ca. 10 Sekunden und ca. 10 Minuten liegen.

Man erhält gut haftende Abbildungen mit hoher Bildqualität.

Die nachfolgenden Beispiele erläutern die Erfindung näher.

A) Herstellung der Zwischenprodukte

Beispiel 1 : N-(Chlormethylcarbonyloxyäthyl)-dimethylmaleinimid

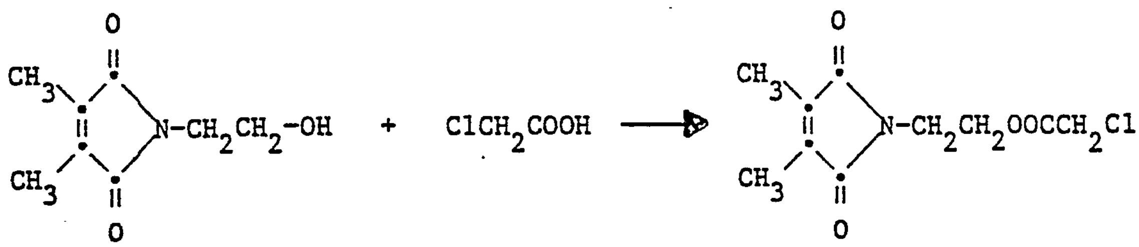

169,2 g (1 Mol) N-(2-hydroxiäthyl)-dimethylmaleinimid, 113,4 g (1,2 Mol) Chloressigsäure und 11,8 g konzentrierte Schwefelsäure werden in 1 000 ml Toluol am Wasserabscheider unter Rühren zum Rückfluss erhitzt. Nach ca. 2 Stunden ist die Bildung von Wasser beendet und es haben sich 18 ml abgeschieden. Die Reaktionslösung wird mit gesättigter Natriumbicarbonatlösung und Wasser gewaschen, die organische Phase über Magnesiumsulfat getrocknet und am Rotationsverdampfer bei 40° eingedampft. Der Rückstand wird unter 0,1 mm Druck bei 60° während 2 Stunden nachgetrocknet. Es verbleiben 206 g einer farblosen Flüssigkeit.

Elementaranalyse : $C_{10}H_{12}ClNO_4$ (245,67)

| | | | |
|---|---|---|---|
| Ber. : | C 48,89 | H 4,92 | N 5,70 |
| Gef. : | C 48,88 | H 5,05 | N 5,58. |

Beispiel 2 : N-(Chlormethylcarbonyloxi-2,2-dimethylpropyl)-dimethylmaleinimid

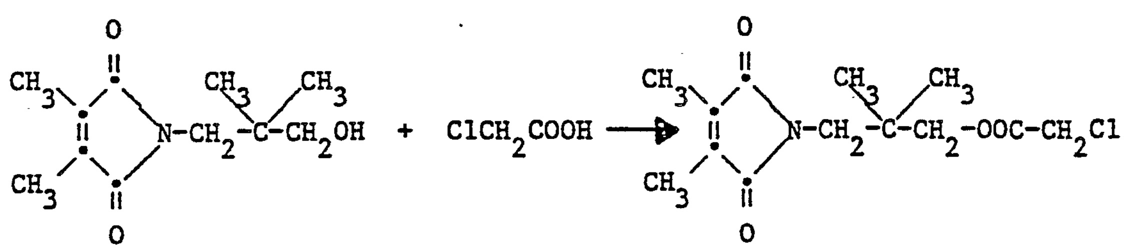

105,6 g (0,5 Mol) N-(2,2-dimethyl-3-hydroxipropyl)-dimethylmaleinimid, 56,7 g (0,6 Mol) Chloressigsäure und 5,9 g konzentrierte Schwefelsäure werden in 400 ml Toluol am Wasserabscheider wie in Beispiel 1 erhitzt, bis die Bildung von Wasser (9 ml) beendet ist. Nach Aufarbeitung der Reaktionslösung gemäss Beispiel 1 verbleiben 121 g farblose Flüssigkeit.

Elementaranalyse : $C_{13}H_{18}ClNO_4$ (287,75)

| | | | | |
|---|---|---|---|---|
| Ber. : | C 54,27 | H 6,31 | N 4,87 | Cl 12,32 |
| Gef. : | C 54,24 | H 6,13 | N 4,92 | Cl 12,13. |

Beispiel 3 : N-(Chlormethylcarbonyloxi-3-oxapentyl)-dimethylmaleinimid

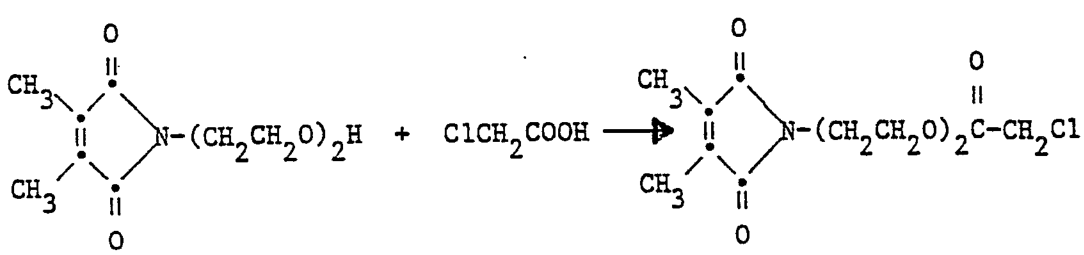

90,6 g (0,41 Mol) N-(5-hydroxi-3-oxapentyl)-dimethyl-maleinimid, 46,6 g Chloressigsäure und 4,8 g konzentrierte Schwefelsäure werden in 400 ml Toluol am Wasserabscheider gemäss Beispiel 1 umgesetzt und aufgearbeitet. Es verbleiben 112 g einer schwach gelblichen Flüssigkeit.

Elementaranalyse : $C_{12}H_{16}ClNO_5$ (289,72)

| | | | | |
|---|---|---|---|---|
| Ber. : | C 49,75 | H 5,57 | N 4,84 | Cl 12,24 |
| Gef. : | C 50,00 | H 5,58 | N 5,01 | Cl 12,13. |

Beispiel 4 : N-(Chlormethylcarbonyloxihexyl)-dimethylmaleinimid

a) 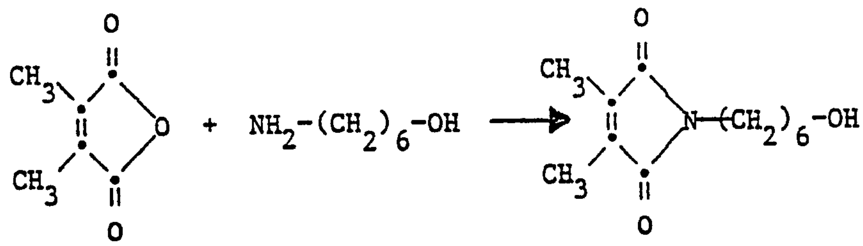

b) 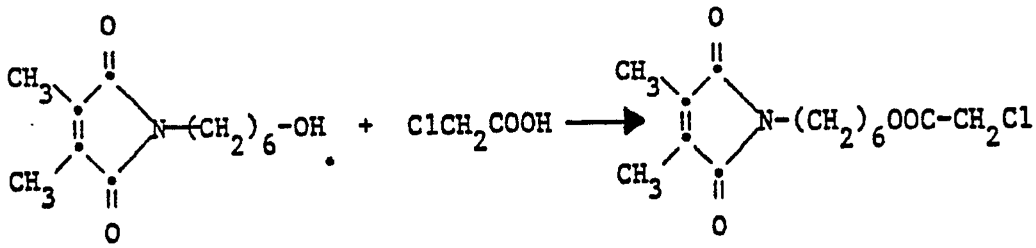

a) In einem 500 ml Glas-Rundkolben mit Magnetrührer und Rückflusskühler wird das Gemisch aus 104,7 g (0,83 Mol) Dimethylmaleinsäureanhydrid, 96,7 g (0,81 Mol) 6-Amino-1-hexanol und 100 ml Toluol während 4 Stunden am Rückfluss erhitzt. Die Reaktionslösung wird zuerst am Wasserstrahlvakuum von flüchtigen Anteilen befreit (Badtemperatur bis 100°) und dann im Oelpumpenvakuum über eine kurze Kolonne fraktioniert. Die Hauptfraktion besteht aus 176 g N-(6-Hydroxihexyl)-dimethylmaleinimid als farbloses Oel, Kp. 130 bis 141/0,05 mm.

b) 67,6 g (0,30 Mol) N-(6-Hydroxihexyl)-dimethylmaleinimid, 34,0 g (0,36 Mol) Chloressigsäure und 3,5 g konzentrierte Schwefelsäure werden in 300 ml Toluol am Wasserabscheider gemäss Beispiel 1 umgesetzt und aufgearbeitet. Es verbleiben 86,6 g eines farblosen Oels.

Elementaranalyse : $C_{14}H_{20}ClNO_4$ (301, 77)

| | | | | |
|---|---|---|---|---|
| Ber. : | C 55,72 | H 6,68 | N 4,64 | Cl 11,75 |
| Gef. : | C 56,80 | H 6,79 | N 4,34 | Cl 11,55. |

B) Herstellung der Polymeren

Beispiel 5

a) Copolymer aus Methylmethacrylat (MMA) und Dimethylaminoäthylmethacrylat (DMAEMA) (Molverhältnis der Monomeren : MMA/DMAEMA = 1,8/1,0)

Ein thermostatisierbarer Doppelmantel-Glasreaktor, versehen mit Rührer, Thermometer, Vakuumanschluss und Stickstoffeinleitung wird mit folgender Mischung beschickt :

| | |
|---|---|
| 36,0 | g MMA |
| 31,4 | g DMAEMA |
| 270,0 | g Aethanol |
| 0,337 | g Azo-bis-isobutyronitril (AIBN) |

Sauerstoff wird durch mehrmaliges Evakuieren und Füllen mit reinem Stickstoff entfernt. Die Polymerisation wird durch Erhitzen auf eine Innentemperatur von 60 ± 1 °C gestartet und während 24 Stunden bei dieser Temperatur durchgeführt. Die viskose Polymerlösung wird in total 3 500 ml Wasser mittels eines Mixers gefällt und das feste, farblose Polymerpulver während 3 Tagen im Vakuumtrockenschrank bei ca. 100 Torr/50 °C getrocknet. Man erhält 59 g Polymer mit einem Amin-Gehalt von 2,68 Val/kg (theoretisch 2,94 Val/kg).

b) Quaternisierung des Polymers

In einem Glaskolben mit Magnetrührer wird die Mischung aus

10,0 g des obigen Polymeren,
8,6 g N-(Chlormethylcarbonyloxi-3-oxapentyl)-dimethylmaleinimid gemäss Beispiel 3,
95,0 ml Dimethylformamid

während 1 Stunde bei 60 °C, dann 24 Stunden bei 80 °C erhitzt. Die gelbliche, viskose Polymerlösung wird unter gutem Rühren in 2 000 ml Essigsäureäthylester gefällt und im Vakuumtrockenschrank/40 °C unter Lichtausschluss getrocknet.

Ausbeute : 16,8 g Polymerpulver, das laut Analyse 4,3 % Cl enthält. Dies entspricht 1,21 Val/kg quaternäre Ammoniumgruppen (theoretisch 1,51 Val/kg). Das Polymere ist in Wasser löslich.

Beispiel 6 : Copolymer MMA/DMAEMA 1,8 : 1, quarternisiert mit Verbindung gemäss Beispiel 1

10,0 g Polymer von Beispiel 5a
7,3 g N-(Chlormethylcarbonyloxiäthyl)-dimethylmaleinimid gemäss Beispiel 1,
95,0 ml DMF

werden analog zu Beispiel 1b umgesetzt.

Ausbeute : 14,2 g festes Polymer, das laut Analyse 4,5 % Cl enthält. Dies entspricht 1,27 Val/kg quaternäre Ammoniumgruppen (theoretisch 1,62 Val/kg). Inhärente Viskosität (0,5 % in Methylcellosolve, 25 °C) = 1,04 dl/g.

Beispiel 7 : Polymerisation und Quaternisierung

Polymer aus :

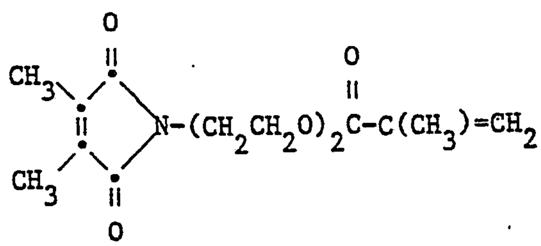

(DMI-o-MA)

$(CH_3)_2NCH_2CH_2OOC-C(CH_3)=CH_2$ (DMAEMA)

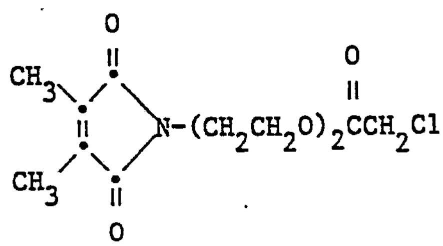

(Beispiel 3)

500 ml — Glasampullen mit Magnetrührer werden mit den folgenden Mischungen beschickt und der Sauerstoff durch mehrmaliges Evakuieren und Füllen mit reinem Stickstoff entfernt. Die Ampullen werden während 24 Stunden in einem auf 65 °C thermostabilisierten Heizbad erhitzt, abgekühlt und der Inhalt in 2 000 ml Aether eingegossen. Die Polymeren fallen als gummiartige Massen an. Der Aether wird abdekantiert, nochmals frischen Aether zugefügt, erneut dekantiert und das Polymere im Vakuumtrockenschrank bei 40 °C/100 mm getrocknet. Die vereinigten Atherphasen werden am Rotationsverdampfer eingedampft, der Rückstand gewogen und daraus der Umsatz berechnet.

7.1 :
28,1 g DMI-o-MA
4,7 g DMAEMA
8,7 g Verbindung Beispiel 3
0,16 g Azo-bis-isobutyronitril
76,5 g Dimethylformamid

Umsatz = 96 % Polymer ist in Wasser löslich.

7.2 :
28,1 g DMI-o-MA
3,1 g DMAEMA
5,8 g Verbindung Beispiel 3
0,16 g Azo-bis-isobutyronitril
72,0 g Dimethylformamid
Umsatz = 96 % Polymer ist in Wasser löslich.

7.3 :
28,1 g DMI-o-MA
3,9 g DMAEMA
7,2 g Verbindung Beispiel 3
0,16 g Azo-bis-isobutyronitril
74,7 g Dimethylformamid

Im Gegensatz zu 7.1 und 7.2 wird das Polymer 7.3 nicht in Aether gefällt sondern die Reaktionslösung direkt zur Herstellung lichtempfindlicher Materialien weiterverwendet.

Beispiel 8 : Polymerisation und Quarternisierung

Polymer aus :

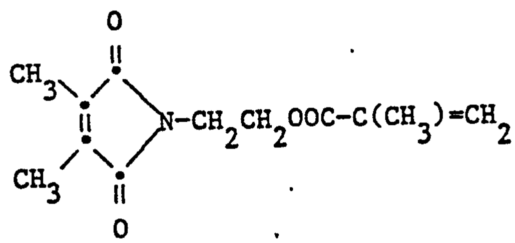

(DMI-MA)

$$(CH_3)_2NCH_2CH_2OOC-C(CH_3)=CH_2$$

(DMAEMA)

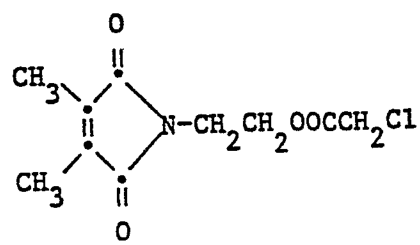

(Beispiel 1)

Analog zu Beispiel 7 werden die folgenden Mischungen polymerisiert :

8.1 :
23,7 g DMI-MA
7,86 g DMAEMA
12,28 g Verbindung Beispiel 1
0,16 g Azo-bis-isobutyronitril
73,7 g Dimethylformamid
Cl-Gehalt (analytisch) = 4,9 %. Dies entspricht 1,38 Val/kg quarternäre Ammoniumgruppen (theoretisch 1,14 Val/kg)

8.2 :
23,7 g DMI-MA
6,3 g DMAEMA
9,83 g Verbindung Beispiel 1
0,20 g Azo-bis-isobutyronitril
93,0 g Dimethylformamid
Umsatz 93 %.

Beispiel 9 : Polymerisation und Quarternisierung

Polymer aus :

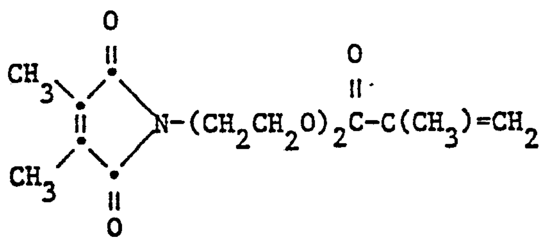 (DMI-o-MA)

$(CH_3)_2NCH_2CH_2OOC-C(CH_3)=CH_2$ (DMAEMA)

$(CH_3O)_2SO_2$ (Dimethylsulfat)

Analog zu Beispiel 7 wird die folgende Mischung polymerisiert :

28,1 g DMI-o-MA
3,1 g DMAEMA
2,52 g Dimethylsulfat
0,16 g Azo-bis-isobutyronitril
72,8 g Dimethylformamid
Umsatz = 97 %. Das Polymer ist löslich in Wasser.

Applikationsbeispiele

Der in den nachfolgenden Beispielen verwendete Sensibilisator mit der Abkürzung CMTX (3-Carbäthoxi-7-methylthioxanthon) besitzt folgende Struktur

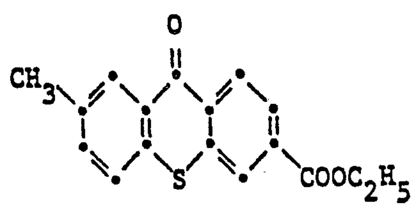

Alle Arbeiten werden unter Gelblicht durchgeführt.

Beispiel 10

Die folgende Beschichtungslösung wird hergestellt :

4,0 g quaternisiertes Polymer von Beispiel 5
16,0 g Aethylenglykolmonomethyläther
0,200 g CMTX

Diese Lösung wird mittels eines Drahtrakels mit 20 μm Nassfilmdicke auf eine biaxial gereckte 100 μm dicke Polyesterfolie beschichtet und 5 Minuten bei 85° getrocknet. Die homogene, leicht gelbliche lichtempfindliche Schicht weist eine Dicke von ca. 3-4 μm auf.

Die Filme werden auf einem Kopierapparat (Océ Helioprint 36, 1 000 W-Metall-Halogenlampe im Abstand von 53 cm) im Kontakt mit einem Testkeil während 30 Sekunden belichtet.

Die belichteten Streifen werden durch Eintauchen in lauwarmes (35 °C) Wasser während 30 Sekunden entwickelt und dann während 3 Minuten in eine 2-%ige wässrige Lösung des Farbstoffs der Formel

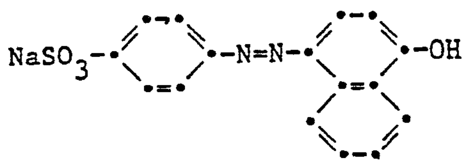

(orange I)

getaucht. Dann wird 15 Sekunden im fliessenden Wasser gewaschen und getrocknet. Man erhält ein intensiv orange gefärbtes Bild, das bei 465 µm eine optische Dichte von 1,7 aufweist.

Beispiel 11

Die folgende Beschichtungslösung :

4,0 g quarternisiertes Polymer von Beispiel 6
16,0 g Aethylenglykolmonomethyläther
0,200 g CMTX

wird wie in Beispiel 11 beschrieben auf Polyester beschichtet, belichtet, mit Wasser von 35 °C während 30 Sekunden entwickelt und eingefärbt. Man erhält ein intensiv orange gefärbtes Bild, das bei 465 um eine optische Dichte von 3,1 aufweist.

Beispiel 12

Folgende Beschichtungslösung wird hergestellt :

3,0 g Polymer gemäss Beispiel 7.1,
7,0 g Lösungsmittelgemisch Methanol/Methylenchlorid 1 : 1,
0,060 g CMTX

Diese Lösung wird mittels eines Drahtrakels mit 120 µm Nassfilmdicke auf ein Kupfer-kaschiertes Laminat, das zur Herstellung von Leiterplatten verwendet wird, beschichtet und 20 Minuten bei 40 °C getrocknet. Die Photopolymer-Schichtdicke dieser beschichteten Leiterplatte beträgt ca. 35 µm. Die Platte wird auf dem in Beispiel 10 beschriebenen Kopierapparat durch einen Teilkeil während 2 Minuten belichtet und durch Auswaschen in fliessendem Wasser (30 °C) während 2 Minuten entwickelt.

Auf diese Platte können nun in bekannter Weise die Leiterzüge durch galvanische Kupferabscheidung verstärkt werden, wobei der Photoresist nicht angegriffen wird. Anschliessend lässt sich der Photoresist durch Behandeln mit warmer 5 %-Natronlauge abstrippen.

Beispiel 13

Folgende Beschichtungslösung wird hergestellt :

4,0 g Polymer gemäss Beispiel 7.2,
16,0 g Aethylenglykolmonomethyläther,
0,320 g CMTX.

Diese Lösung wird mittels eines Drahtrakels mit 20 µm Nassfilmdicke auf ein Kupfer-kaschiertes Laminat, dass zur Herstellung von Leiterplatten dient, beschichtet und 3 Minuten bei 85 °C getrocknet. Die Platte wird wie in Beispiel 10 während 30 Sekunden belichtet, und durch Schwenken in Wasser von 35 °C während 2 Minuten entwickelt.

Dann wird in bekannter Weise mit Eisen(III)-chloridlösung geätzt und so das Leiterbahnenmuster erzeugt. Dabei wird der Photoresist durch die Aetzlösung nicht angegriffen. Er lässt sich, falls gewünscht, durch Behandeln mit warmer Natriumhydroxidlösung wegstrippen.

Beispiel 14

Folgende Beschichtungslösung wurde hergestellt :

20,0 g Polymerlösung in Dimethylformamid gemäss Beispiel 7.3,
0,140 g CMTX,
0,420 g Citronensäure

Diese Lösung wird mittels eines Drahtrakels mit 120 µm Nassfilmdicke auf ein Kupfer-kaschiertes Laminat, das zur Herstellung von Leiterplatten dient, beschichtet und während 25 Minuten bei 85° getrocknet. Die Platte wird wie in Beispiel 10 während 3 Minuten belichtet und mit einer Handbrause mit

Wasser von 35 °C während 2 Minuten entwickelt. Der entwickelte Photoresist kann nun wie in Beispiel 12 als Galvanoresist dienen, er widersteht dem Angriff der stark sauren galvanischen Bäder sehr gut und ergibt Leiterbahnenmuster von hoher Qualität.

**Patentansprüche**

1. Maleinimidylgruppen und quarternäre Ammoniumgruppen enthaltende Homopolymere oder Copolymere mit einem Molekulargewicht von mindestens 1 000, gekennzeichnet durch Strukturelemente der Formel I

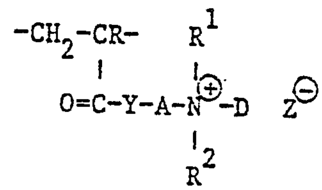

(I)

worin

R ein Wasserstoffatom oder Methyl ist,

Y ein Sauerstoffatom oder die NH-Gruppe bedeutet,

A lineares oder verzweigtes $C_2$-$C_6$-Alkylen ist,

$R^1$ und $R^2$ unabhängig voneinander $C_1$-$C_4$ Alkyl oder zusammen Tetramethylen, Pentamethylen oder 3-Oxapentylen sind,

D $C_1$-$C_4$-Alkyl oder ein Rest der Formeln

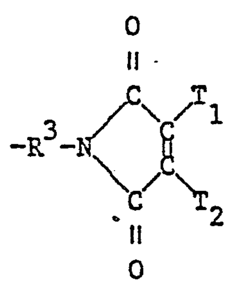 , 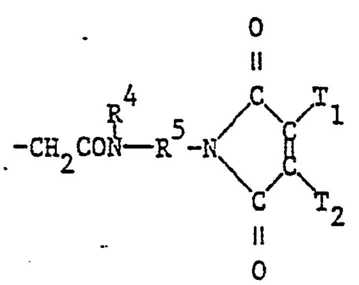 , 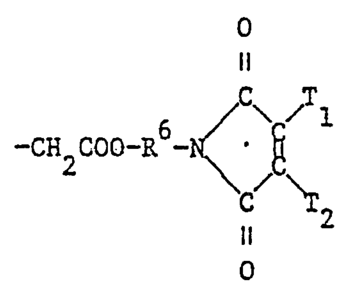

bedeutet, worin $R^3$ Alkylen, Oxaalkylen oder Benzylen ist, $R^4$ ein Wasserstoffatom oder $C_1$-$C_4$-Alkyl ist, $R^5$ ein zweiwertiger aliphatischer, cycloaliphatischer oder aromatischer Kohlenwasserstoffrest oder ein zweiwertiger aliphatischer oder aromatischer heterocyclischer Rest mit bis zu 18 C-Atomen darstellt und $R^6$ die Bedeutung von $R^5$ hat oder

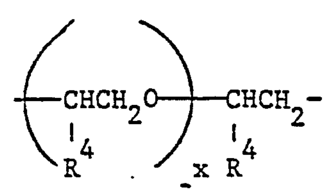

mit x gleich 1-29 und $R^4$ gleich einem Wasserstoffatom oder $C_1$-$C_4$-Alkyl ist, $T_1$ und $T_2$ unabhängig voneinander $C_1$-$C_4$-Alkyl oder zusammen unsubstituiertes oder durch $C_1$-$C_4$-Alkyl substituiertes Tri- oder Tetramethylen sind, und $Z^\ominus$ ein Anion ist, mit der Massgabe, dass, falls D gleich $C_1$-$C_4$-Alkyl ist, im Polymer Strukturelemente von mindestens einem äthylenisch ungesättigten Monomer, das eine Maleinimidylgruppe der Formel

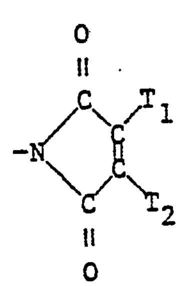

trägt, enthalten sind, wobei noch zusätzliche Strukturelemente, die sich von äthylenisch ungesättigten maleinimidgruppenfreien Comonomeren ableiten, vorhanden sein können.

2. Polymere gemäss Anspruch 1, dadurch gekennzeichnet, dass sie die Strukturelemente der Formel I zu 5 bis 90 Mol-%, bezogen auf das Polymer, enthalten.

3. Polymere gemäss Anspruch 1, dadurch gekennzeichnet, dass sie 10 bis 100 Mol-%, bezogen auf das Polymer, Strukturelemente mit Maleinimidylgruppen

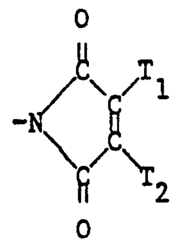

enthalten, worin $T_1$ und $T_2$ die zuvor angegebene Bedeutung haben.

4. Polymere gemäss Anspruch 1, dadurch gekennzeichnet, dass sie als Strukturelemente von Comonomeren mit Maleinimidylgruppen solche der Formeln

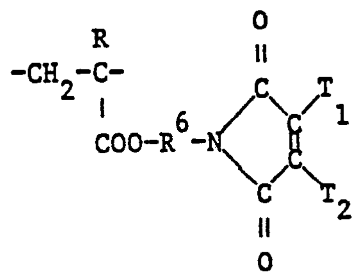

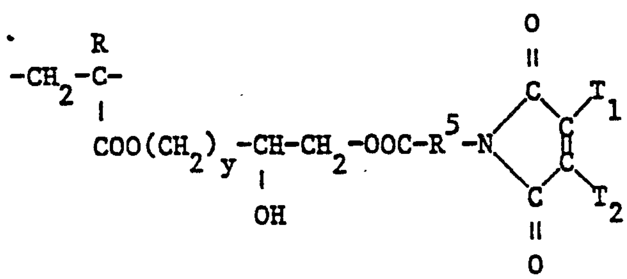

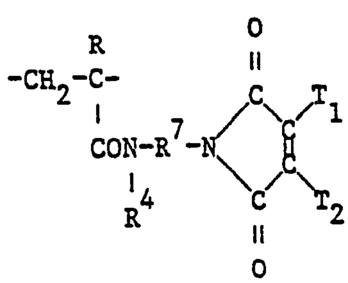

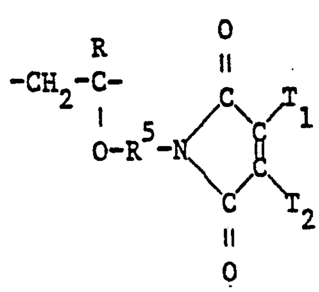

enthalten, worin R, $R^4$, $R^5$, $R^6$ und $T_1$ die in Anspruch 1 angegebenen Bedeutungen haben, $R^7$ gleich $R^5$ oder

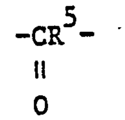

ist und y für 1 oder 2 steht.

5. Polymere gemäss Anspruch 1, dadurch gekennzeichnet, dass sie zusätzlich Strukturelemente von Comonomeren aus der Gruppe der α-Olefine, Vinylhalogenide, aromatischen Vinylverbindungen, heterocyclischen Vinylverbindungen, Vinylketone, Vinylester, Vinyläther und α,β-ungesättigter Nitrile, Carbonsäureester und Carbonsäureamide enthalten.

6. Polymere gemäss Anspruch 1, dadurch gekennzeichnet, dass $R^5$ als aliphatischer Rest Alkylen oder Oxaalkylen mit 1 bis 12 C-Atomen ist, als cycloaliphatischer Rest 5 oder 6 Ringatome, als carbocyclisch-aromatischer Rest 6 bis 16 C-Atome, als araliphatischer Rest 7-16 C-Atome und als heterocyclisch aromatischer oder heterocyclisch aliphatischer Rest 4-12 C-Atome enthält.

7. Verfahren zur Herstellung von Polymeren gemäss Anspruch 1, dadurch gekennzeichnet, dass man

a) ein Homo- oder Copolymeres mit Strukturelementen der Formeln II oder III

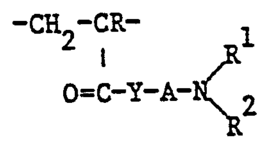 (II) 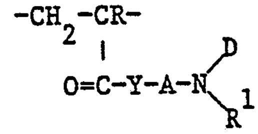 (III)

in einem organischen Lösungsmittel mit einem Quarternisierungsmittel der Formeln D-Z bzw. $R^2Z$ umsetzt, worin R, $R^1$, $R^2$, Y, A, D und Z die in Anspruch 1 angegebene Bedeutung haben, oder

b) dass man Monomere der Formel IV

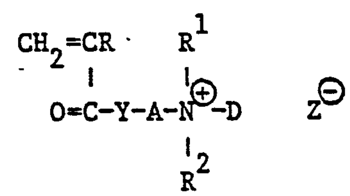 (IV)

alleine oder zusammen mit einem äthylenisch ungesättigten Comonomeren in organischer Lösung in Gegenwart eines Radikalinitiators polymerisiert, oder

c) dass man ein Monomer der Formeln V oder VI

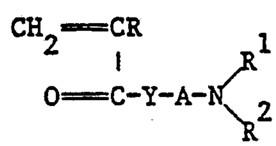 (V) 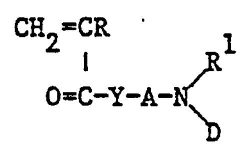 (VI)

alleine oder zusammen mit einem äthylenisch ungesättigten Comonomer in organischer Lösung in Gegenwart eines Radikalinitiators und in Gegenwart eines Quarternierungsmittels DZ bzw. $R^2Z$ polymerisiert, wobei R, $R^1$, $R^2$, Y, A, D und Z die in Anspruch 1 angegebene Bedeutung haben.

8. Verwendung von Verbindungen der Formel IV

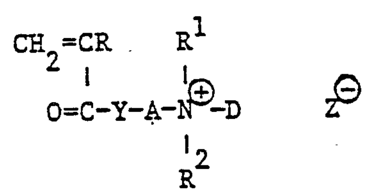 (IV)

in einem Verfahren gemäss Anspruch 7, wobei R ein Wasserstoffatom oder Methyl, Y ein Sauerstoff oder die NH-Gruppe, A lineares oder verzweigtes $C_2$-$C_6$-Alkylen, $R^1$ und $R^2$ unabhängig voneinander lineares oder verzweigtes Alkyl oder zusammen Pentamethylen, Tetramethylen oder 3-Oxapentylen, $Z^{\ominus}$ das Anion eines Quarternierungsmittels und D ein Maleinimidylrest der Formeln

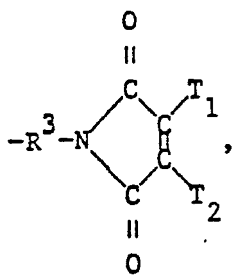, 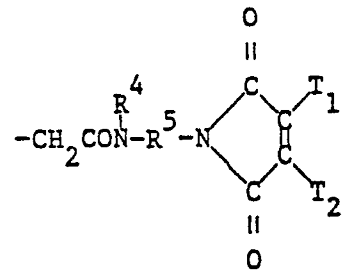, 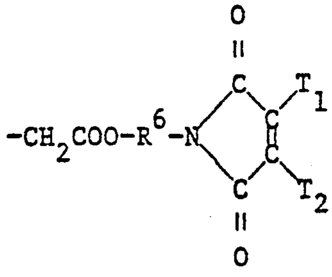

bedeuten, worin $R^3$ Alkylen, Oxaalkylen oder Benzylen ist, $R^4$ ein Wasserstoffatom oder $C_1$-$C_4$-Alkyl ist, $R^5$ ein zweiwertiger aliphatischer, cycloaliphatischer oder aromatischer Kohlenwasserstoffrest oder ein zweiwertiger aliphatischer oder aromatischer heterocyclischer Rest mit bis zu 18 C-Atomen darstellt und $R^6$ die Bedeutung von $R^5$ hat oder

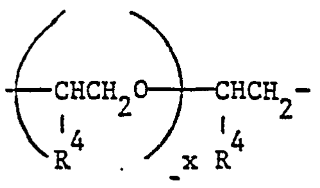

mit x gleich 1-29 und $R^4$ gleich einem Wasserstoffatom oder $C_1$-$C_4$-Alkyl ist, $T_1$ und $T_2$ unabhängig voneinander $C_1$-$C_4$-Alkyl oder zusammen unsubstituiertes oder durch $C_1$-$C_4$-Alkyl substituiertes Tri- oder Tetramethylen sind.

9. Verwendung von Verbindungen der Formel VII

$$D—Z \qquad (VII)$$

als Quarternierungsmittel in einem Verfahren gemäss Anspruch 7, wobei Z für Halogen, eine Sulfonat- oder Sulfatgruppe steht und D ein Maleinimidylrest der Formeln

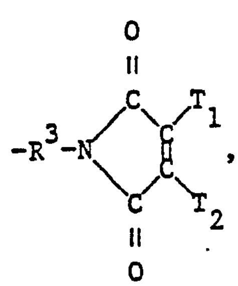, 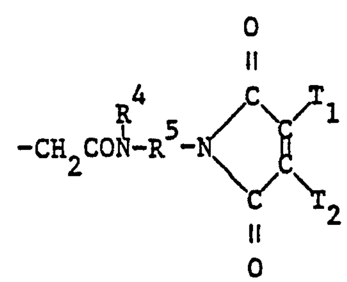, 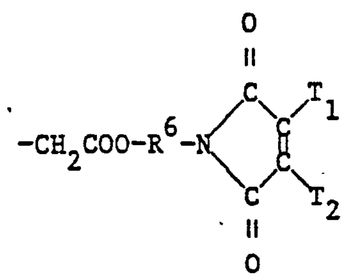

bedeutet, worin $R^3$ Alkylen, Oxaalkylen oder Benzylen ist, $R^4$ ein Wasserstoffatom oder $C_1$-$C_4$-Alkyl ist, $R^5$ ein zweiwertiger aliphatischer, cycloaliphatischer oder aromatischer Kohlenwasserstoffrest oder ein zweiwertiger aliphatischer oder aromatischer heterocyclischer Rest mit bis zu 18 C-Atomen darstellt und $R^6$ die Bedeutung von $R^5$ hat oder

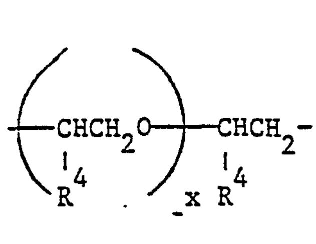

mit x gleich 1-29 und $R^4$ gleich einem Wasserstoffatom oder $C_1$-$C_4$-Alkyl ist, $T_1$ und $T_2$ unabhängig voneinander $C_1$-$C_4$-Alkyl oder zusammen unsubstituiertes oder durch $C_1$-$C_4$-Alkyl substituiertes Tri- oder Tetramethylen sind.

10. Verwendung von Polymeren gemäss Anspruch 1 als photographisches Aufzeichnungsmaterial, besonders für graphische Filme, Druckplatten, gedruckte Schaltungen und hochintegrierten Schaltkreisen.

11. Photographisches Aufzeichnungsmaterial aus einem Trägermaterial, auf welchem unmittelbar eine Schicht eines Polymeren gemäss Anspruch 1 und gegebenenfalls übliche Zusätzen aufgebracht ist.

**Claims**

1. Homopolymers or copolymers containing maleimidyl and quaternary ammonium groups and having a molecular weight of at least 1 000, which polymer contains structural units of the formula I

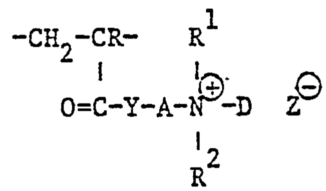

(I)

wherein

R is a hydrogen atom or methyl,

Y is an oxygen atom or the —NH group,

A is linear or branched $C_2$-$C_6$-alkylene,

$R^1$ and $R^2$ independently of each other are $C_1$-$C_4$-alkyl or together are tetramethylene, pentamethylene or 3-oxapentylene,

D is $C_1$-$C_4$-alkyl or a radical of the formulae

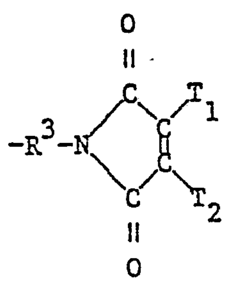 , 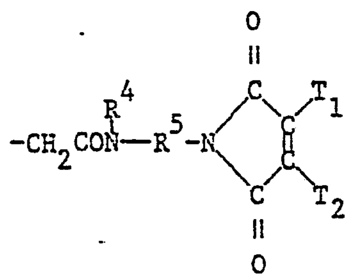 , 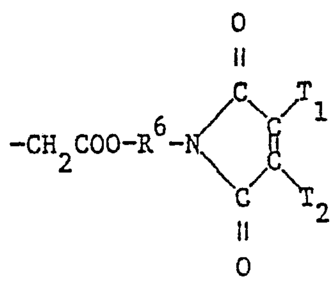

wherein $R^3$ is alkylene, oxaalkylene or benzylene, $R^4$ is a hydrogen atom or $C_1$-$C_4$-alkyl, $R^5$ is a bivalent aliphatic, cycloaliphatic or aromatic hydrocarbon radical or a bivalent aliphatic or aromatic heterocyclic radical containing up to 18 carbon atoms, and $R^6$ has the meaning of $R^5$ or is

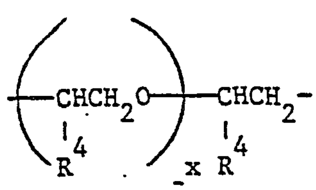

wherein x is a value from 1 to 29 and $R^4$ is a hydrogen atom or $C_1$-$C_4$-alkyl ; and $T_1$ and $T_2$ independently of each other are $C_1$-$C_4$-alkyl or together are unsubstituted or $C_1$-$C_4$-alkyl-substituted trimethylene or tetramethylene, and $Z^{\ominus}$ is an anion, with the proviso that, if D is $C_1$-$C_4$-alkyl, structural units of at least one ethylenically unsaturated monomer which carries a maleimidyl group of the formula

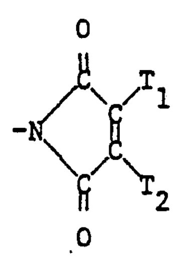

are present in the polymer, and additional structural units which are derived from ethylenically unsaturated comonomers which do not contain maleimide groups may also be present.

2. Polymers according to claim 1, which contain 5 to 90 mol % of the structural units of the formula I, based on the polymer.

3. Polymers according to claim 1, which contain 10 to 100 mol %, based on the polymer, of structural units containing maleimidyl groups

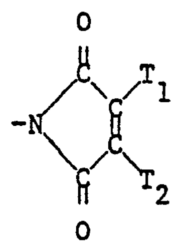

wherein $T_1$ and $T_2$ have the given meanings.

4. Polymers according to claim 1, which contain as structural units of comonomers containing maleimidyl groups those of the formulae

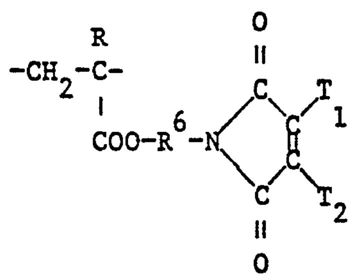

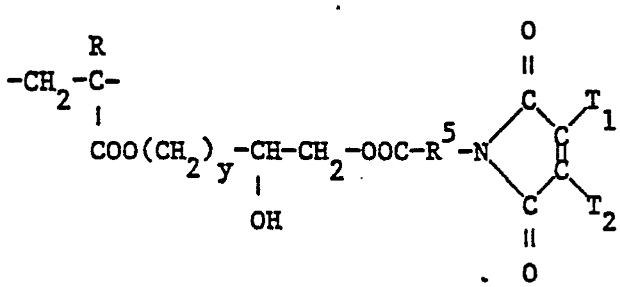

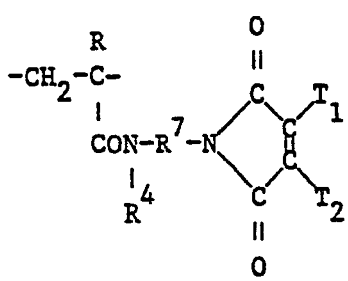

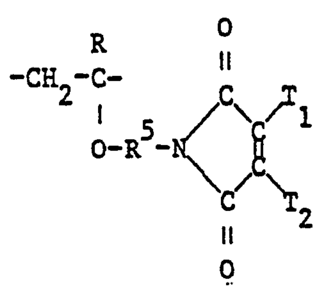

wherein R, $R^4$, $R^5$, $R^6$ and $T_1$ are as defined in claim 1, $R^7$ has the same meaning as $R^5$ or is

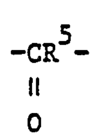

and y is 1 or 2.

5. Polymers according to claim 1, which additionally contain structural units of comonomers from the group of α-olefins, vinyl halides, aromatic vinyl compounds, heterocyclic vinyl compounds, vinyl ketones, vinyl esters, vinyl ethers and α,β-unsaturated nitriles, carboxylic acid esters and carboxylic acid amides.

6. Polymers according to claim 1, wherein $R^5$ as an aliphatic radical is alkylene or oxaalkylene containing 1 to 12 carbon atoms, and as a cycloaliphatic radical contains 5 or 6 ring atoms, as a carbocyclic aromatic radical contains 6 to 16 carbon atoms, as an araliphatic radical contains 7 to 16 carbon atoms, and as a heterocyclic-aromatic or heterocyclic-aliphatic radical contains 4 to 12 carbon atoms.

7. A process for the preparation of polymers according to claim 1, which comprises

a) reacting a homopolymer or copolymer containing structural units of the formula II or III

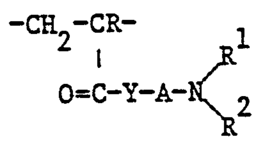 (II) 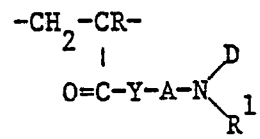 (III)

with a quaternizing agent of the formula D-Z or $R^2Z$, in which formulae R, $R^1$, $R^2$, Y, A, D and Z are as defined in claim 1, in an organic solvent, or

b) polymerizing monomers of the formula IV

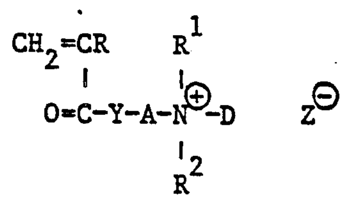 (IV)

by themselves or together with an ethylenically unsaturated comonomer, in organic solution and in the presence of a radical initiator, or

c) polymerizing a monomer of the formula V or VI

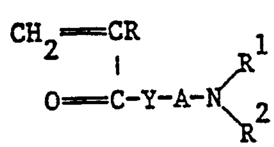 (V) 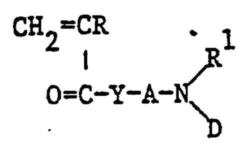 (VI)

by itself or together with an ethylenically unsaturated comonomer, in organic solution and in the presence of a radical initiator and in the presence of a quaternizing agent DZ or $R^2Z$, in which formulae R, $R^1$, $R^2$, Y, A, D and Z are as defined in claim 1.

8. Use of compounds of the formula IV

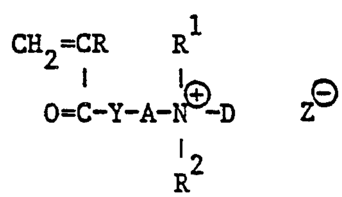 (IV)

in a process according to claim 7, wherein R is a hydrogen atom or methyl, Y is an oxygen or the —NH group, A is linear or branched $C_2$-$C_6$-alkylene, $R^1$ and $R^2$ independently of each other are linear or branched alkyl or together are pentamethylene, tetramethylene or 3-oxapentylene, $Z^{\ominus}$ is the anion of a quaternizing agent and D is a maleimidyl radical of the formulae

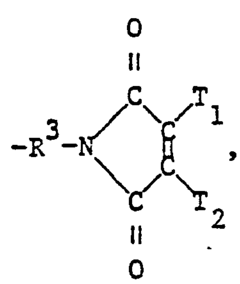 , 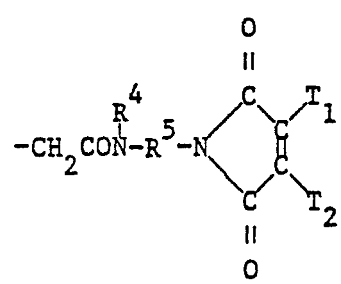 , 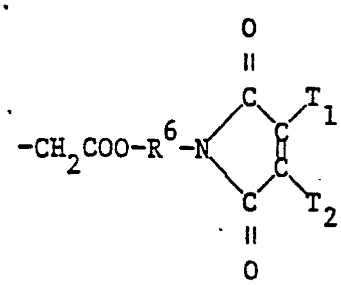

wherein $R^3$ is alkylene, oxaalkylene or benzylene, $R^4$ is a hydrogen atom or $C_1$-$C_4$-alkyl, $R^5$ is a bivalent aliphatic, cycloaliphatic or aromatic hydrocarbon radical or a bivalent aliphatic or aromatic heterocyclic radical containing up to 18 carbon atoms, and $R^6$ has the meaning of $R^5$ or is

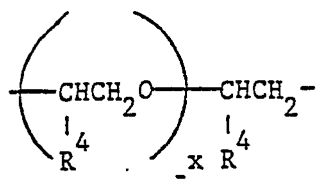

wherein x is a value from 1 to 29 and $R^4$ is a hydrogen atom or $C_1$-$C_4$-alkyl ; and $T_1$ and $T_2$ independently of each other are $C_1$-$C_4$-alkyl or together are unsubstituted or $C_1$-$C_4$-alkyl-substituted trimethylene or tetramethylene.

9. Use of compounds of the formula VII

$$D—Z \qquad (VII)$$

as quaternizing agents in a process according to claim 7, wherein Z is halogen, a sulfonate or sulfate group and D is a maleimidyl radical of the formulae

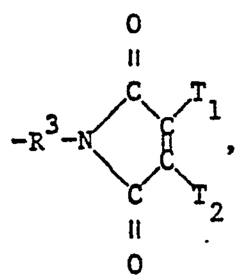 , 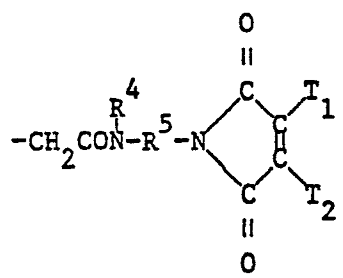 , 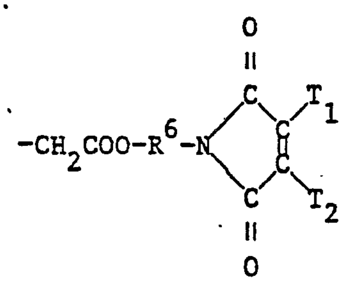

wherein $R^3$ is alkylene, oxaalkylene or benzylene, $R^4$ is a hydrogen atom or $C_1$-$C_4$-alkyl, $R^5$ is a bivalent aliphatic, cycloaliphatic or aromatic hydrocarbon radical or a bivalent aliphatic or aromatic heterocyclic radical containing up to 18 carbon atoms, and $R^6$ has the meaning of $R^5$ or is

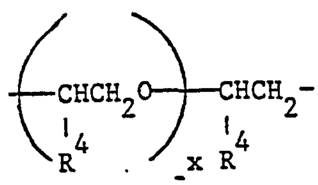

wherein x is a value from 1 to 29 and $R^4$ is a hydrogen atom or $C_1$-$C_4$-alkyl ; and $T_1$ and $T_2$ independently of each other are $C_1$-$C_4$-alkyl or together are unsubstituted or $C_1$-$C_4$-alkyl-substituted trimethylene or tetramethylene.

10. Use of polymers according to claim 1 as photographic recording material, in particular for graphic films, printing plates, printed circuits and highly integrated switching circuits.

11. A photographic recording material comprising a support to which has been applied directly a layer of a polymer according to claim 1 and optionally conventional additives.

**Revendications**

1. Homopolymères ou copolymères contenant des radicaux maléimidyles et des radicaux d'ammoniums quaternaires et ayant une masse moléculaire moyenne d'au moins 1 000, qui sont caractérisés en ce qu'ils comportent des motifs répondant à la formule I :

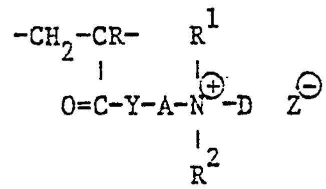

(I)

dans laquelle :

R représente un atome d'hydrogène ou un méthyle,

Y représente un atome d'oxygène ou le radical —NH—,

A représente un alkylène en $C_2$-$C_6$, linéaire ou ramifié,

$R^1$ et $R^2$ représentent chacun, indépendamment l'un de l'autre, un alkyle en $C_1$-$C_4$ ou forment ensemble un radical tétraméthylène, pentaméthylène ou oxa-3 pentylène,

D représente un alkyle en $C_1$-$C_4$ ou un radical répondant à l'une des formules suivantes :

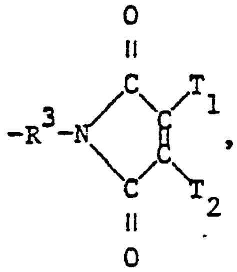 , 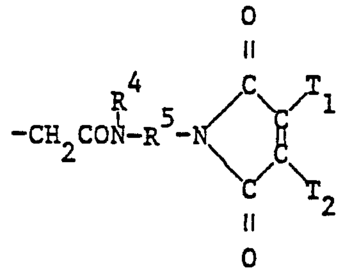 , et 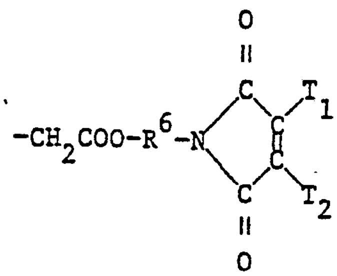

dans lesquelles $R^3$ représente un alkylène, un oxa-alkylène ou un benzylène, $R^4$ un atome d'hydrogène ou un alkyle en $C_1$-$C_4$, $R^5$ un radical hydrocarboné bivalent aliphatique, cycloaliphatique ou aromatique ou un radical hétérocyclique bivalent aliphatique ou aromatique qui contient au plus 18 atomes de carbone et $R^6$ a la signification qui a été donnée pour $R^5$ ou représente un radical :

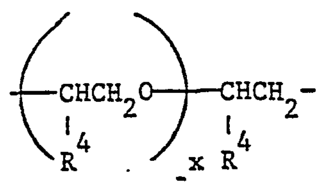

(dans lequel x désigne un nombre de 1 à 29 et $R^4$ un atome d'hydrogène ou un alkyle en $C_1$-$C_4$), et $T_1$ et $T_2$ représentent chacun, indépendamment l'un de l'autre, un alkyle en $C_1$-$C_4$ ou forment ensemble un radical triméthylène ou tétraméthylène non substitué ou porteur d'un alkyle en $C_1$-$C_4$, et $Z^\ominus$ représente un anion, avec la condition que, dans le cas où D représente un alkyle en $C_1$-$C_4$, il y ait, dans le polymère, des motifs d'au moins un monomère éthylénique porteur d'un radical maléimidyle de formule :

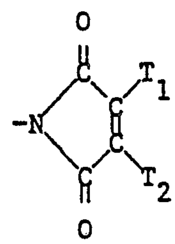

la présence de motifs supplémentaires dérivant de comonomères éthyléniques sans radicaux maléimidyles étant également possible.

2. Polymères selon la revendication 1 caractérisés en ce qu'ils contiennent des motifs de formule I en une proportion de 5 à 90 % en moles par rapport au polymère.

3. Polymères selon la revendication 1 caractérisés en ce qu'ils contiennent de 10 à 100 % en moles, par rapport au polymère, de motifs à radicaux maléimidyles répondant à la formule :

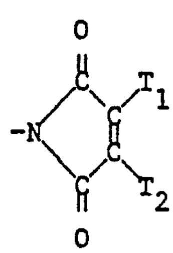

dans laquelle $T_1$ et $T_2$ ont les significations précédemment données.

4. Polymères selon la revendication 1 caractérisés en ce qu'ils contiennent, comme motifs de comonomères à radicaux maléimidyles, des motifs répondant aux formules suivantes :

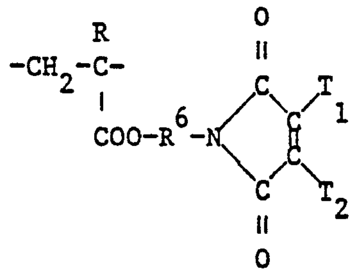

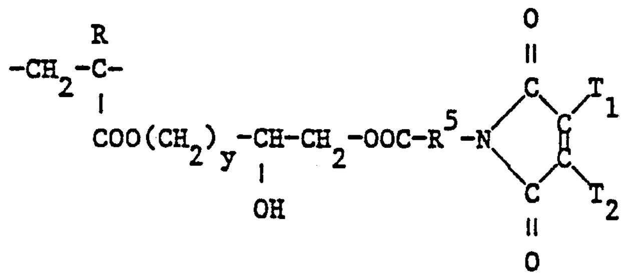

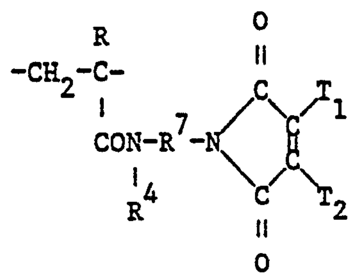

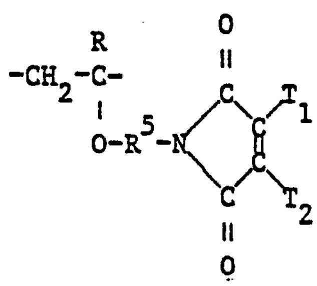

dans lesquelles R, $R^4$, $R^5$, $R^6$ et $T_1$ ont les significations données à la revendication 1, $R^7$ a la signification de $R^5$ ou représente un radical

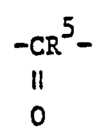

et y désigne le nombre 1 ou le nombre 2.

5. Polymères selon la revendication 1 caractérisés en ce qu'ils contiennent en outre des motifs de comonomères pris dans l'ensemble constitué par les α-oléfines, les halogénures de vinyles, les composés vinyliques aromatiques, les composés vinyliques hétérocycliques, les vinylcétones, les esters vinyliques, les éthers vinyliques et les nitriles, esters et amides d'acides carboxyliques insaturés en α, β.

6. Polymères selon la revendication 1 caractérisés en ce que $R^5$, lorsqu'il est un radical aliphatique, est un radical alkylène ou oxa-alkylène contenant de 1 à 12 atomes de carbone, et en ce qu'il contient, lorsqu'il est un radical cycloaliphatique, 5 ou 6 atomes de carbone dans le cycle, lorsqu'il est un radical carbocyclique-aromatique de 6 à 16 atomes de carbone, lorsqu'il est un radical araliphatique de 7 à 16 atomes de carbone et lorsqu'il est un radical hétérocyclique-aromatique ou hétérocyclique-aliphatique de 4 à 12 atomes de carbone.

7. Procédé de préparation de polymères selon la revendication 1, procédé caractérisé en ce que :

a) on fait réagir un homopolymère ou copolymère comportant des motifs de formule II ou de formule III :

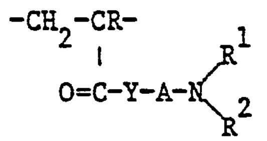 (II) 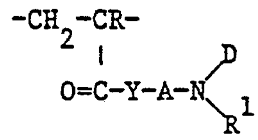 (III)

dans un solvant organique, avec un agent de quaternisation répondant respectivement à la formule D—Z ou à la formule $R^2Z$, formules dans lesquelles R, $R^1$, $R^2$, Y, A, D et Z ont les significations données à la revendication 1, ou

b) on polymérise des monomères de formule IV :

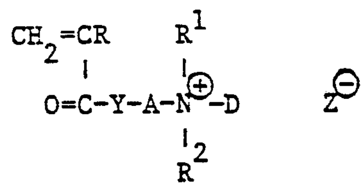 (IV)

isolément ou en association avec un comonomère éthylénique, en solution organique, en présence d'un amorceur radicalaire, ou

c) on polymérise un monomère de formule V ou de formule VI :

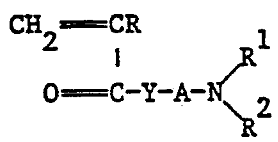 (V) 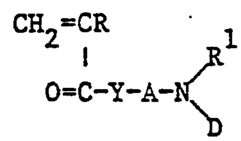 (VI)

isolément ou en association avec un comonomère éthylénique, en solution organique, en présence d'un amorceur radicalaire et en présence d'un agent de quaternisation répondant respectivement à la formule DZ ou à la formule $R^2Z$, formules dans lesquelles R, $R^1$, $R^2$, Y, A, D et Z ont les significations données à la revendication 1.

8. Application, dans un procédé selon la revendication 7, de composés répondant à la formule IV :

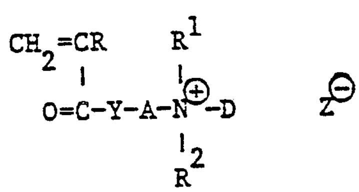 (IV)

dans laquelle :

R représente un atome d'hydrogène ou un radical méthyle,

Y représente l'oxygène ou un radical —NH—,

A représente un alkylène en $C_2$-$C_6$ linéaire ou ramifié,

$R^1$ et $R^2$ représentent chacun, indépendamment l'un de l'autre, un alkyle linéaire ou ramifié ou forment ensemble un radical pentaméthylène, tétraméthylène ou oxa-3 pentylène,

$Z^{\ominus}$ représente l'anion d'un agent de quaternisation et

D représente un radical maléimidyle répondant à l'une des formules :

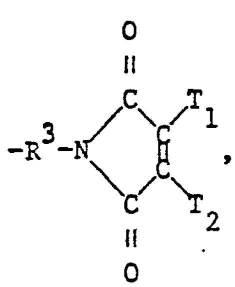 , 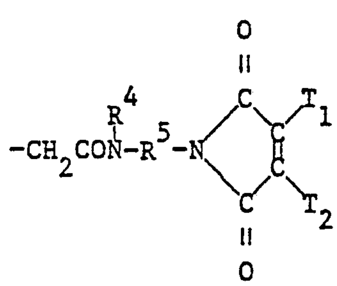 , et 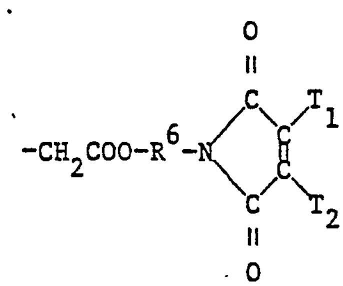

dans lesquelles $R^3$ représente un radical alkylène, oxa-alkylène ou pentylène, $R^4$ un atome d'hydrogène ou un alkyle en $C_1$-$C_4$, $R^5$ un radical hydrocarboné bivalent aliphatique, cycloaliphatique ou aromatique ou un radical bivalent hétérocyclique-aliphatique ou hétérocyclique-aromatique contenant au plus 18 atomes de carbone, $R^6$ a la signification de $R^5$ ou représente un radical :

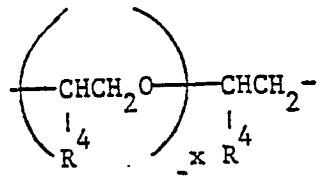

(dans lequel x désigne un nombre de 1 à 29 et $R^4$ représente un atome d'hydrogène ou un alkyle en $C_1$-$C_4$), et $T_1$ et $T_2$ représentent chacun, indépendamment l'un de l'autre, un alkyle en $C_1$-$C_4$ ou forment ensemble un radical triméthylène ou tétraméthylène non substitué ou porteur d'un alkyle en $C_1$-$C_4$.

9. Application, comme agents de quaternisation dans un procédé selon la revendication 7, de composés répondant à la formule VII :

$$D—Z \qquad (VII)$$

dans laquelle Z représente un halogène, un radical sulfonate ou un radical sulfate et D un radical maléimidyle répondant à l'une des formules suivantes :

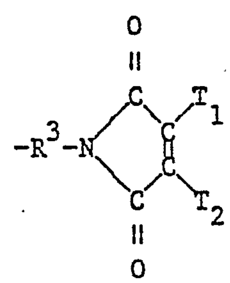 , 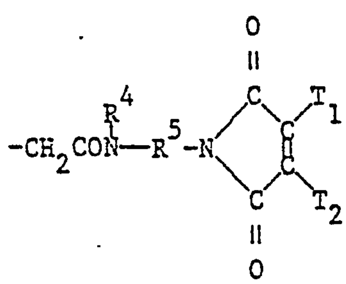 , et 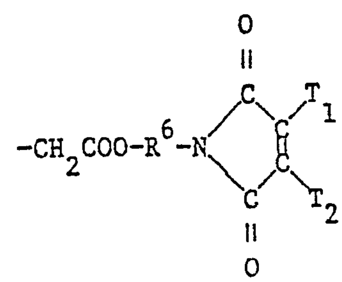

dans lesquelles $R^3$ représente un radical alkylène, oxa-alkylène ou pentylène, $R^4$ un atome d'hydrogène ou un alkyle en $C_1$-$C_4$, $R^5$ un radical hydrocarboné bivalent aliphatique, cycloaliphatique ou aromatique ou un radical bivalent hétérocyclique-aliphatique ou hétérocyclique-aromatique contenant au plus 18 atomes de carbone, $R^6$ a la signification de $R^5$ ou représente un radical :

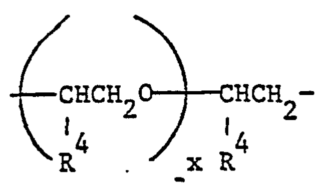

(dans lequel x désigne un nombre de 1 à 29 et $R^4$ représente un atome d'hydrogène ou un alkyle en $C_1$-$C_4$), et $T_1$ et $T_2$ représentent chacun, indépendamment l'un de l'autre, un alkyle en $C_1$-$C_4$ ou forment ensemble un radical triméthylène ou tétraméthylène non substitué ou porteur d'un alkyle en $C_1$-$C_4$.

10. Application de polymères selon la revendication 1 comme matière d'enregistrement photographique, en particulier pour des pellicules graphiques, des plaques d'impression, des circuits imprimés et des circuits intégrés à grande intégration.

11. Matière d'enregistrement photographique constituée d'une matière-support sur laquelle est appliquée directement une couche constituée d'un polymère selon la revendication 1 et, éventuellement, d'additifs usuels.